# EUROPÄISCHE PATENTSCHRIFT

(11) **EP 2 962 388 B1**
(45) Veröffentlichungstag und Bekanntmachung des Hinweises auf die Patenterteilung: **24.04.2019**
(21) Anmeldenummer: 14708787.8
(22) Anmeldetag: 05.02.2014
(51) Int. Cl.: G01P 3/00, H02P 29/024, G01R 31/34, H02H 7/06, H02P 9/00, H02P 9/10

(54) **VERFAHREN ZUR ERKENNUNG VON POLSCHLUPF**
METHOD FOR IDENTIFYING POLE SLIP
PROCÉDÉ DE RECONNAISSANCE DE GLISSEMENT DE PÔLE

(30) Priorität: 28.02.2013 AT 1562013
(43) Veröffentlichungstag der Anmeldung: 06.01.2016
(73) Patentinhaber: Innio Jenbacher GmbH & Co OG, 6200 Jenbach (AT)
(72) Erfinder: FAHRINGER, Albert, A-6345 Kössen (AT)
(74) Vertreter: Torggler & Hofinger Patentanwälte
(86) Internationale Anmeldenummer: PCT/AT2014/000023
(87) Internationale Veröffentlichungsnummer: WO 2014/138757

(56) Entgegenhaltungen:
- WO-A2-2013/102849
- DE-A1- 2 823 201
- DE-A1- 2 920 735
- US-A1- 2010 039 077

## Beschreibung

Die Erfindung betrifft ein Verfahren zur Erkennung von Polschlupf eines mit einem Energieversorgungsnetz elektrisch verbundenen elektrischen Generators, insbesondere Synchrongenerators, wobei ein Rotor des Generators mit einer Motorwelle einer Brennkraftmaschine, insbesondere eines Gasmotors, mechanisch verbunden ist, wobei die Brennkraftmaschine in einem stationären Betriebsmodus mit einer im Wesentlichen konstanten mechanischen Rotationsfrequenz betrieben wird sowie eine entsprechend ausgebildete Polschlupferkennungsvorrichtung.

Bei mit einem Energieversorgungsnetz (z.B. öffentliches Energieversorgungsnetz oder lokales Energieversorgungsnetz im Inselbetrieb) verbundenen Synchrongeneratoren drückt der Polradwinkel bzw. Lastwinkel bekanntermaßen die Abweichung der Magnetpole am Rotor des Generators von den Magnetpolen am Stator des Generators aus. Die Magnetpole am Rotor werden dabei üblicherweise durch eine Gleichstrom-gespeiste Erregerwicklung am Rotor erzeugt und die Magnetpole am Stator des Generators werden durch die an entsprechende Wicklungen am Stator angelegte elektrische Spannung des Energieversorgungsnetzes, welches typischerweise dreiphasig ausgeführt ist, erzeugt. Der Polradwinkel beschreibt somit im Zeigermodell den Winkel zwischen der Ständerspannung und der Rotorspannung bzw. Polradspannung, wobei die Rotorspannung im Generatorbetrieb des Synchrongenerators der Ständerspannung voraus eilt. Bei steigender Belastung durch das Energieversorgungsnetz, d.h. bei erhöhter Energiebereitstellung durch den Generator, erhöht sich dieser Polradwinkel. Wird der Polradwinkel zu groß, führt dies zu einer Instabilität des Generators, bei der die von der Brennkraftmaschine über die mit dem Rotor verbunden Motorwelle eingebrachte mechanische Leistung nicht mehr wie gewünscht in elektrische Leistung umgewandelt werden kann und die Brennkraftmaschine beginnt hochzudrehen. Dieses Kippen in den instabilen Betriebszustand wird bekanntermaßen als Polschlupf bezeichnet.

Die DE2920735 A1 zeigt ein Verfahren zur Überwachung des Wertes des Polradwinkels.

Aus der US2010039077 A1 ist ein Verfahren zur Beurteilung des Polradwinkels bekannt, bei dem eine von einer Permanentmagnetmaschine erzeugte Wellenform mit der von einer Hauptmaschine erzeugten Wellenform als Maß für den Polradwinkel herangezogen und verglichen werden.

Die DE2823201 A1 zeigt eine Schutzeinrichtung zur Überwachung der Grenzen der Stabilität einer Synchronmaschine, wobei zwei zu einer vorhandenen Wirkleistung gehörenden Polradwinkel verglichen werden.

Da Polschlupf und das damit verbundene Hochdrehen der Brennkraftmaschine Schäden an der Brennkraftmaschine und am Generator anrichten kann, ist es wünschenswert, Polschlupf zu vermeiden oder zu erkennen, um bei Erkennen von Polschlupf entsprechend reagieren und einem Hochdrehen der Brennkraftmaschine entgegenwirken zu können.

Aufgabe der Erfindung ist es daher, ein einfaches Verfahren anzugeben, um Polschlupf zu erkennen.

Diese Aufgabe wird erfindungsgemäß durch ein Verfahren mit den Merkmalen des Patentanspruchs 1 sowie durch eine Polschlupferkennungsvorrichtung mit den Merkmalen des Patentanspruchs 7 gelöst. Vorteilhafte Ausgestaltungen der Erfindung sind in den abhängigen Patentansprüchen angegeben.

Es ist vorgesehen, dass die mechanische Rotationsfrequenz der Motorwelle und eine elektrische Rotationsfrequenz des Energieversorgungsnetzes erfasst oder ermittelt werden, wobei bei einer Abweichung der mechanischen Rotationsfrequenz von der elektrischen Rotationsfrequenz größer eines vorgebbaren Schwellwerts ein Signal ausgegeben wird, wobei das Signal als detektierter Polschlupf angesehen wird.

Bei Auftreten von Polschlupf beginnt die Brennkraftmaschine - ausgehend von ihrer im Wesentlichen konstanten Drehzahl während des stabilen stationären Betriebsmodus - hochzudrehen. Dieses Hochdrehen kann als Abweichung der mechanischen Rotationsfrequenz der Motorwelle von der elektrischen Rotationsfrequenz der Statorspannung erkannt und als Polschlupf detektiert werden.

Der Vorteil des vorgeschlagenen Verfahrens liegt insbesondere in der Einfachheit. Die zur Erfassung bzw. Ermittlung der mechanischen und elektrischen Rotationsfrequenz benötigte Sensorik ist üblicherweise in handelsüblichen Brennkraftmaschinen und Generatoren verbaut, da im Rahmen von Motor- oder Generatorüberwachungssystemen üblicherweise die Motordrehzahl und die Netzfrequenz überwacht werden. Mit dem vorgeschlagenen Verfahren sind also keine darüber hinaus benötigten Sensoren erforderlich.

Um Fehlalarme zu verhindern, kann vorzugsweise vorgesehen sein, dass das Signal ausgegeben wird, falls die Abweichung größer des vorgebbaren Schwellwerts während eines vorgebbaren Zeitraums besteht. Dadurch kann insbesondere vermieden werden, dass während eines Synchronisationsvorgangs des Generators mit dem Energieversorgungsnetz ein Polschlupfalarm ausgelöst wird.

Gemäß einer besonders bevorzugten Ausführungsform kann vorgesehen sein, dass bei detektiertem Polschlupf die elektrische Verbindung zwischen elektrischem Generator und Energieversorgungsnetz getrennt wird. Es kann aber auch vorgesehen sein, dass das ausgegebene Signal dazu verwendet wird, dass es bei Auftreten von Polschlupf an einen Polschlupfzähler gemeldet wird, wobei der Polschlupfzähler inkrementiert wird, wobei vorzugsweise bei Überschreiten des Polschlupfzählers über einen vorgebbaren Wartungsschwellwert ein Wartungssignal ausgegeben wird. Dabei kann vorgesehen sein, dass der vorgebbare Wartungsschwellwert in einem Bereich von 2 bis 10, vorzugsweise 3 bis 5, liegt. Robuste Generatoren können bei Auftreten von Polschlupf durchaus mit dem Energieversorgungsnetz verbunden bleiben. Es kann daher auch vorgesehen sein, dass das Wartungssignal herangezogen wird, um die elektrische Verbindung zwischen Generator und Energieversorgungsnetz erst nach dem Auftreten einer einstellbaren Häufigkeit von Polschlupfen zu trennen. Generell kann das Auftreten eines jeweiligen Polschlupfes auch protokolliert werden.

In einer bevorzugten Ausführungsform kann vorgesehen sein, dass als mechanische Rotationsfrequenz eine Motordrehzahl oder Motorfrequenz der Motorwelle oder eine Rotordrehzahl oder Rotorfrequenz des Rotors und als elektrische Rotationsfrequenz eine Netzfrequenz des Energieversorgungsnetzes erfasst oder ermittelt werden, wobei die mechanische Rotationsfrequenz und die elektrische Rotationsfrequenz auf dieselbe Einheit umgerechnet werden. Dabei kann vorzugsweise vorgesehen sein, dass als mechanische Rotationsfrequenz die Motordrehzahl der Motorwelle erfasst wird und die Netzfrequenz des Energieversorgungsnetzes erfasst wird, wobei als elektrische Rotationsfrequenz die Netzfrequenz mit einem vorgebbaren Multiplikator multipliziert wird, wobei vorzugsweise der Multiplikator dem Wert einer Division der Motordrehzahl im stationären Betriebsmodus der Brennkraftmaschine geteilt durch die Netzfrequenz entspricht. So kann beispielsweise die erfasste Motordrehzahl 3000 Umdrehungen pro Minute und die erfasste Netzfrequenz 50 Hz betragen. Um die beiden erfassten Werte auf dieselbe Einheit umzurechnen, kann beispielsweise die erfasste Netzfrequenz mit einem Multiplikator multipliziert werden, dessen Wert einer Division der erfassten Motordrehzahl geteilt durch die Netzfrequenz entspricht, in diesem Beispiel also 3000 Umdrehungen pro Minute geteilt durch 50 Hz. Damit liegen sowohl die mechanische Rotationsfrequenz (3000 Umdrehungen pro Minute) als auch die elektrische Rotationsfrequenz (3000 Umdrehungen pro Minute) in derselben Einheit vor.

Gemäß einem bevorzugten Ausführungsbeispiel kann vorgesehen sein, dass der vorgebbare Schwellwert größer 10, vorzugsweise größer 50, besonders bevorzugt größer 100, Umdrehungen pro Minute beträgt.

Weitere Einzelheiten und Vorteile der vorliegenden Erfindung werden anhand der nachfolgenden Figurenbeschreibung erläutert. Darin zeigen:
- Fig. 1: ein schematisches Blockschaltbild eines mit einem Energieversorgungsnetz elektrisch verbundenen Generators, der von einer Brennkraftmaschine angetrieben wird,
- Fig. 2: den zeitlichen Verlauf einer beispielhaften Abweichung von mechanischer Rotationsfrequenz zu elektrischer Rotationsfrequenz und
- Fig. 3: eine Detaildarstellung der Abweichung aus Fig. 2 sowie eine Polschlupferkennung.

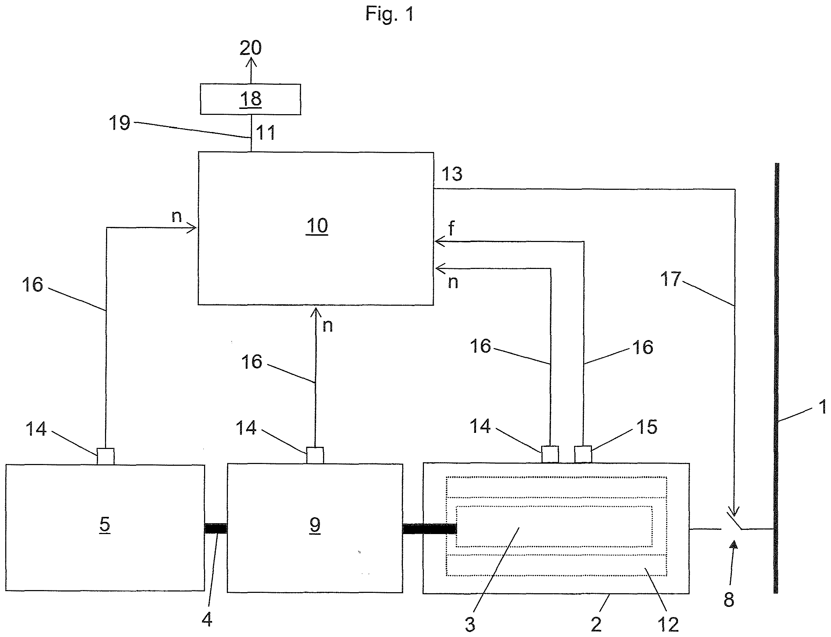

Figur 1 zeigt schematisch einen elektrischen Synchrongenerator 2, der über eine elektrische Verbindungseinrichtung 8 in Form eines Netzschalters mit einem elektrischen Energieversorgungsnetz 1 verbunden ist. Der Rotor 3 bzw. Läufer des Synchrongenerators 2 ist über eine Kupplung 9 mit einer Motorwelle 4 einer Brennkraftmaschine 5 im Wesentlichen drehfest verbunden. Bei der Brennkraftmaschine 5 kann es sich bspw. um einen stationären Gasmotor handeln, der als fremdgezündete, ottomotorisch betriebene Hubkolbenmaschine ausgebildet sein kann. Das Energieversorgungsnetz 1 kann in Form eines Drehstromnetzes dreiphasig ausgebildet sein, wobei die drei Phasen des Energieversorgungsnetzes 1 in bekannter Art und Weise mit Wicklungen am Stator 12 des Generators 2 verbunden sein können. Beim Energieversorgungsnetz 1 kann es sich um ein öffentliches Energieversorgungsnetz handeln, das die Netzfrequenz vorgibt oder beispielsweise um ein lokales Energieversorgungsnetz im Inselbetrieb, bei dem die Netzfrequenz vom Generator vorgegeben wird.

Für das vorgeschlagene Verfahren werden nun eine mechanische Rotationsfrequenz n und eine elektrische Rotationsfrequenz f des Energieversorgungsnetzes 1 mit im Stand der Technik bekannten Sensoren 14, 15 erfasst und über Signalleitungen 16 an eine Auswerteeinheit 10 gemeldet. Beim Sensor 14 zur Erfassung der mechanische Rotationsfrequenz n kann es sich beispielsweise um einen an der Brennkraftmaschine 5, der Kupplung 9 oder dem Rotor 3 angeordneten Drehzahlsensor handeln, der die Zahnflanken eines Zahnrades abtastet aus der erfassten Zeitdifferenz zwischen der Abtastung der Zahnflanken die mechanische Rotationsfrequenz n ermittelt. Beim Sensor 15 zur Erfassung der elektrischen Rotationsfrequenz f des Energieversorgungsnetzes 1 kann es sich um einen Netzfrequenzsensor handeln, welcher beispielsweise die Nulldurchgänge der Netzspannung erfasst und aus der erfassten Zeitdifferenz zwischen den Nulldurchgängen die elektrische Rotationsfrequenz f des Energieversorgungsnetzes 1 ermittelt.

Bei der mechanischen Rotationsfrequenz n kann es sich also bspw. um die Drehzahl der Brennkraftmaschine 5 handeln und bei der elektrischen Rotationsfrequenz f kann es sich bspw. um die Netzfrequenz des Energieversorgungsnetzes 1 handeln. Die Erfassung der mechanischen Rotationsfrequenz n kann dabei mittels Drehzahlsensor 14 direkt an der Motorwelle 4 der Brennkraftmaschine 5, in der Kupplung 9 oder bspw. auch am rotierenden Rotor 3 des Generators 2 erfolgen. Die Erfassung der elektrischen Rotationsfrequenz f kann mittels Netzfrequenzsensor 15 am Stator 12 des Generators 2 erfolgen.

Um eine Abweichung zwischen mechanischer Rotationsfrequenz n und elektrischer Rotationsfrequenz f ermitteln zu können, kann gegebenenfalls eine Umrechnung von mechanischer Rotationsfrequenz n und/oder elektrischer Rotationsfrequenz f erfolgen, sodass sowohl die mechanische Rotationsfrequenz n als auch die elektrische Rotationsfrequenz f in derselben Einheit vorliegen.

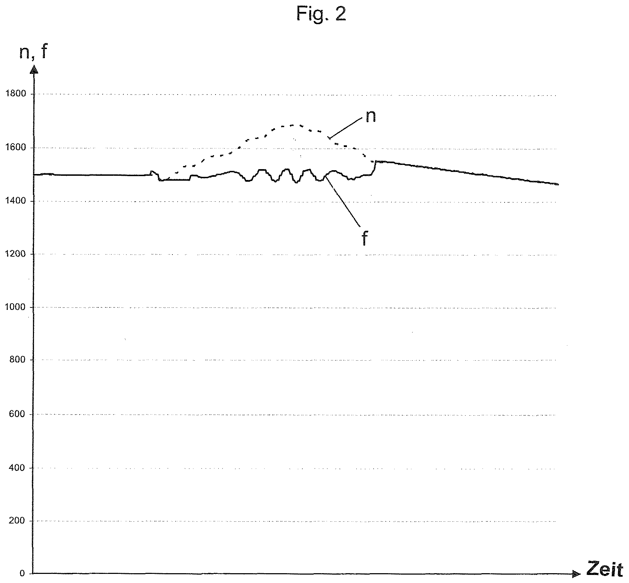

Die Auswerteeinheit 10 ermittelt fortlaufend die Abweichung 6 der mechanischen Rotationsfrequenz n von der elektrischen Rotationsfrequenz f, wobei bei einer Abweichung 6 größer eines vorgebbaren Schwellwerts 7 ein Signal 11 ausgegeben wird, wobei das Signal 11 als detektierter Polschlupf angesehen wird (siehe Fig. 2). Das Signal 11 wird im gezeigten Beispiel über eine Zählleitung 19 an einen Polschlupfzähler 18 gemeldet, der das Auftreten von detektiertem Polschlupf zählt und bei Überschreiten eines vorgebbaren Wartungsschwellwerts ein Wartungssignal 20 ausgibt.

Es kann auch vorgesehen sein, dass das Signal 11 an eine Überwachungsvorrichtung des Generators 2 oder der Brennkraftmaschine 5 gemeldet wird.

Vorzugsweise kann auch vorgesehen sein, dass bei detektiertem Polschlupf die elektrische Verbindungseinrichtung 8 zwischen elektrischem Generator 2 und Energieversorgungsnetz 1 getrennt wird. Für diese Zwecke kann bspw. die Auswerteeinheit 10 ein entsprechendes Schaltsignal 13 über eine Schaltleitung 17 an die elektrische Verbindungseinrichtung 8 senden, wobei durch das Schaltsignal 13 das Trennen der elektrischen Verbindung durch Öffnen der Verbindungseinrichtung 8 ausgelöst wird.

Figur 2 zeigt beispielhaft zeitliche Verläufe von mechanischer Rotationsfrequenz n und elektrischer Rotationsfrequenz f des Energieversorgungsnetzes 1 einer Anordnung gemäß Figur 1. Die Solldrehzahl liegt dabei bei 1500 Umdrehungen pro Minute. In der Abbildung ist zu erkennen, dass die mechanische Rotationsfrequenz n zeitweise von der elektrischen Rotationsfrequenz f abweicht.

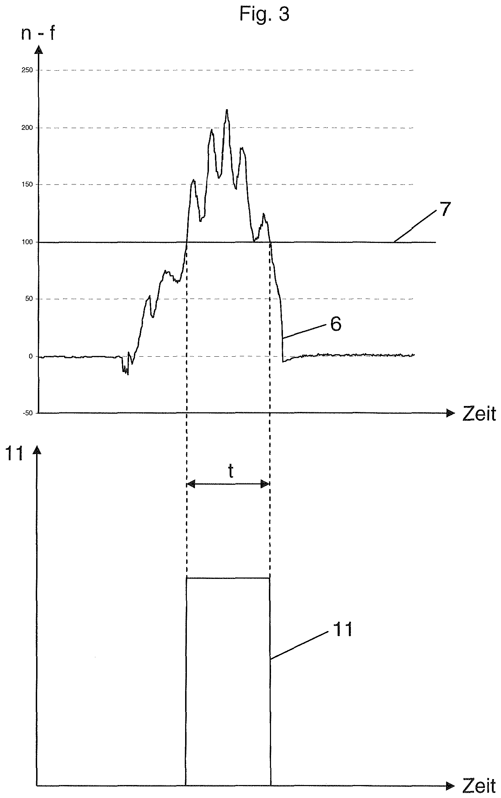

Figur 3 zeigt den zeitlichen Verlauf der von der Auswerteeinheit 10 erfassten Abweichung 6 der mechanischen Rotationsfrequenz n von der elektrischen Rotationsfrequenz f gemäß Figur 2. In diesem Beispiel ist ein Schwellwert 7 von 100 Umdrehungen pro Minute vorgesehen. Mit anderen Worten soll bei einer Abweichung 6 von mehr als 100 Umdrehungen pro Minute ein Signal 11 ausgegeben werden, das als detektierter Polschlupf angesehen wird. Wie der Abbildung zu entnehmen ist, wird dieser Schwellwert 7 während des Zeitraums t überschritten, wodurch während des Zeitraums t ein entsprechendes Signal 11 ausgegeben wird.

## Patentansprüche

1. Verfahren zur Erkennung von Polschlupf eines mit einem Energieversorgungsnetz (1) elektrisch verbundenen elektrischen Generators (2), insbesondere Synchrongenerators, wobei ein Rotor (3) des Generators (2) mit einer Motorwelle (4) einer Brennkraftmaschine (5), insbesondere eines Gasmotors, mechanisch verbunden ist, wobei die Brennkraftmaschine (5) in einem stationären Betriebsmodus mit einer im Wesentlichen konstanten mechanischen Rotationsfrequenz (n) betrieben wird, wobei die mechanische Rotationsfrequenz (n) der Motorwelle (4) und eine elektrische Rotationsfrequenz (f) des Energieversorgungsnetzes (1) erfasst oder ermittelt werden, **dadurch gekennzeichnet, dass** die mechanische Rotationsfrequenz (n) und die elektrische Rotationsfrequenz (f) auf dieselbe Einheit umgerechnet werden, wobei bei einer Abweichung (6) der mechanischen Rotationsfrequenz (n) von der elektrischen Rotationsfrequenz (f), falls die Abweichung (6) größer eines vorgebbaren Schwellwerts (7) während eines vorgebbaren Zeitraums besteht, ein Signal (11) ausgegeben wird, wobei das Signal (11) als detektierter Polschlupf angesehen wird.

2. Verfahren nach Anspruch 1, **dadurch gekennzeichnet, dass** bei detektiertem Polschlupf die elektrische Verbindung zwischen elektrischem Generator (2) und Energieversorgungsnetz (1) getrennt wird.

3. Verfahren nach Anspruch 1 oder 2, **dadurch gekennzeichnet, dass** als mechanische Rotationsfrequenz (n) die Motordrehzahl der Motorwelle (4) erfasst wird und die Netzfrequenz des Energieversorgungsnetzes (1) erfasst wird, wobei als elektrische Rotationsfrequenz (f) die Netzfrequenz mit einem vorgebbaren Multiplikator multipliziert wird, wobei vorzugsweise der Multiplikator dem Wert einer Division der Motordrehzahl im stationären Betriebsmodus der Brennkraftmaschine (5) geteilt durch die Netzfrequenz entspricht.

4. Verfahren nach einem der Ansprüche 1 bis 3, **dadurch gekennzeichnet, dass** der vorgebbare Schwellwert (7) größer 10, vorzugsweise größer 50, besonders bevorzugt größer 100, Umdrehungen pro Minute beträgt.

5. Verfahren nach einem der Ansprüche 1 bis 4, **dadurch gekennzeichnet, dass** das Signal (11) an einen Polschlupfzähler (18) gemeldet wird, wobei der Polschlupfzähler (18) inkrementiert wird, wobei vorzugsweise bei Überschreiten des Polschlupfzählers (18) über einen vorgebbaren Wartungsschwellwert ein Wartungssignal (20) ausgegeben wird.

6. Verfahren nach Anspruch 5, **dadurch gekennzeichnet, dass** der vorgebbare Wartungsschwellwert in einem Bereich von 2 bis 10, vorzugsweise 3 bis 5, liegt.

7. Polschlupferkennungsvorrichtung zur Erkennung von Polschlupf eines mit einem Energieversorgungsnetz (1) elektrisch verbundenen elektrischen Generators (2), insbesondere Synchrongenerators, wobei ein Rotor (3) des Generators (2) mit einer Motorwelle (4) einer Brennkraftmaschine (5), insbesondere eines Gasmotors, mechanisch verbunden ist, wobei ein Drehzahlsensor (14) zur Erfassung einer mechanischen Rotationsfrequenz (n) der Motorwelle (4) und ein Netzfrequenzsensor (15) zur Erfassung einer elektrischen Rotationsfrequenz (f) des Energieversorgungsnetzes (1) vorgesehen sind, wobei eine Auswerteeinheit (10) vorgesehen ist, wobei Signalleitungen (16) dazu ausgebildet sind, die erfasste mechanische Rotationsfrequenz (n) und die erfasste elektrische Rotationsfrequenz (f) an die Auswerteeinheit (10) zu melden, wobei die Auswerteeinheit (10) dazu ausgebildet ist, eine Abweichung (6) der mechanischen Rotationsfrequenz (n) von der elektrischen Rotationsfrequenz (f) zu ermitteln, **dadurch gekennzeichnet, dass** die Auswerteeinheit (10) dazu ausgebildet ist, die mechanische Rotationsfrequenz (n) und die elektrische Rotationsfrequenz (f) auf dieselbe Einheit umzurechnen und bei einer Abweichung (6) größer eines vorgebbaren Schwellwerts (7) während eines vorgebbaren Zeitraums ein als detektierter Polschlupf angesehenes Signal (11) auszugeben.

8. Polschlupferkennungsvorrichtung nach Anspruch 7, **dadurch gekennzeichnet, dass** der elektrische Generator (2) über eine Verbindungseinrichtung (8), vorzugsweise einen Netzschalter, elektrisch mit dem Energieversorgungsnetz (1) verbunden ist, wobei die Auswerteeinheit (10) dazu ausgebildet ist, bei detektiertem Polschlupf über eine Schaltleitung (17) ein Schaltsignal (13) an die Verbindungseinrichtung (8) zu melden, wobei durch das Schaltsignal (13) die Öffnung der Verbindungseinrichtung (8) ausgelöst wird.

9. Polschlupferkennungsvorrichtung nach Anspruch 7 oder 8, **dadurch gekennzeichnet, dass** ein - vorzugsweise inkrementierbarer - Polschlupfzähler (18) vorgesehen ist, wobei die Zählleitung (19) dazu ausgebildet ist, das Signal (11) über eine Zählleitung (19) an den Polschlupfzähler (18) zu melden, wobei vorzugsweise bei Überschreiten des Polschlupfzählers (18) über einen vorgebbaren Wartungsschwellwert ein Wartungssignal (20) ausgegeben wird.

## Claims

1. A method of identifying pole slip of an electrical generator (2), in particular a synchronous generator, electrically connected to a power supply network (1), wherein a rotor (3) of the generator (2) is mechanically connected to an engine shaft (4) of an internal combustion engine (5), in particular a gas engine, wherein the internal combustion engine (5) is operated in a steady operating mode with a substantially constant mechanical rotational frequency (n), wherein the mechanical rotational frequency (n) of the engine shaft (4) and an electrical rotational frequency (f) of the power supply network (3) are detected or ascertained, **characterised in that** the mechanical rotational frequency (n) and the electrical rotational frequency (f) are converted to the same unit by calculation, wherein upon a deviation (6) in the mechanical rotational frequency (n) from the electrical rotational frequency (f) of greater than a predeterminable threshold value (7) during a predeterminable period of time a signal (11) is output, wherein the signal (11) is considered as a detected pole slip.

2. A method as set forth in claim 1 **characterised in that** in the event of detected pole slip the electrical connection between the electrical generator (2) and the power supply network (1) is separated.

3. A method as set forth in claim 1 or 2 **characterised in that** the rotary engine speed of the engine shaft (4) is detected as the mechanical rotational frequency (n) and the network frequency of the power supply network (1) is detected, wherein the network frequency is multiplied by a predeterminable multiplier as the electrical rotational frequency (f), wherein preferably the multiplier corresponds to the value of a division of the rotary engine speed in the steady operating mode of the internal combustion engine (5) divided by the network frequency.

4. A method as set forth in one of claims 1 through 3 **characterised in that** the predeterminable threshold value (7) is greater than 10, preferably greater than 50, particularly preferably greater than 100, revolutions per minute.

5. A method as set forth in one of claims 1 through 4 **characterised in that** the signal (11) is signaled to a pole slip counter (18), wherein the pole slip counter (18) is incremented, wherein preferably a maintenance signal (20) is output when the pole slip counter (18) exceeds a predeterminable maintenance threshold value.

6. A method as set forth in claim 5 **characterised in that** the predeterminable maintenance threshold value is in a range of between 2 and 10, preferably between 3 and 5.

7. A pole slip identification device for the identification of pole slip of an electrical generator (2), in particular a synchronous generator, electrically connected to a power supply network (1), wherein a rotor (3) of the generator (2) is mechanically connected to an engine shaft (4) of an internal combustion engine (5), in particular a gas engine, wherein there are provided a rotary speed sensor (14) for detecting a mechanical rotational frequency (n) of the engine shaft (4) and a network frequency sensor (15) for detecting an electrical rotational frequency (f) of the power supply network (1), wherein an evaluation unit (10) is provided, wherein signal lines (16) are designed to signal the detected mechanical rotational frequency (n) and the detected electrical rotational frequency (f) to the evaluation unit (10), wherein evaluation unit (10) is designed to determine a deviation (6) in the mechanical rotational frequency (n) from the electrical rotational frequency (f), **characterised in that** the evaluation unit (10) is designed to convert the mechanical rotational frequency (n) and the electrical rotational frequency (f) to the same unit and the output upon a deviation (6) greater that a predeterminable threshold value (7) during a predeterminable period of time a signal (11) considered as detected pole slip.

8. A pole slip identification device as set forth in claim 7 **characterised in that** the electrical generator (2) is electrically connected to the power supply network (1) by way of a connecting device (8), preferably a network switch, wherein the evaluation unit is designed to signal a switching signal (13) when pole slip is detected to the connecting device (8) by way of a switching line (17), wherein opening of the connecting device (8) is triggered by the switching signal (13).

9. A pole slip identification device as set forth in claim 7 or claim 8 **characterised in that** there is provided a - preferably incrementable - pole slip counter (18), wherein a counting line (19) is designed to signal the signal (11) to the pole slip counter (18) by way of a counting line (19), wherein preferably a maintenance signal (20) is output when the pole slip counter (18) exceeds a predeterminable maintenance threshold value.

## Revendications

1. Procédé de reconnaissance de glissement de pôle d'un générateur électrique (2), plus particulièrement d'un générateur synchrone, relié électriquement à un réseau d'alimentation en énergie (1), dans lequel un rotor (3) du générateur (2) est relié mécaniquement à un arbre de moteur (4) d'une machine à combustion interne (5), plus particulièrement d'un moteur à gaz, dans lequel le moteur à combustion interne (5) est actionné dans un mode de fonctionnement fixe avec une fréquence de rotation mécanique (n) essentiellement constante, dans lequel la fréquence de rotation mécanique (n) de l'arbre de moteur (4) et une fréquence de rotation électrique (f) du réseau d'alimentation en énergie (1) sont détectées ou déterminées, **caractérisé en ce que** la fréquence de rotation mécanique (n) et la fréquence de rotation électrique (f) sont converties dans la même unité, dans lequel, en cas d'écart (6) de la fréquence de rotation mécanique (n) par rapport à la fréquence de rotation électrique (f), si l'écart (6) est supérieur à une valeur de seuil pouvant être prédéfinie (7) pendant une période pouvant être prédéfinie, un signal (11) est émis, le signal (11) étant considéré comme la détection d'un glissement de pôle.

2. Procédé selon la revendication 1, **caractérisé en ce que** lors de la détection d'un glissement de pôle, la connexion électrique entre le générateur électrique (2) et le réseau d'alimentation en énergie (1) est coupée.

3. Procédé selon la revendication 1 ou 2, **caractérisé en ce que** la vitesse du moteur de l'arbre de moteur (4) est détectée comme fréquence de rotation mécanique (n) et la fréquence de réseau du réseau d'alimentation en énergie (1) est détectée, dans lequel comme fréquence de rotation électrique (f), la fréquence de réseau est multipliée par un multiplicateur pouvant être prédéfini, dans lequel, de préférence, le multiplicateur correspond à la valeur d'une division de la vitesse de rotation du moteur dans un mode de fonctionnement stationnaire de la machine à combustion interne (5) divisée par la fréquence de réseau.

4. Procédé selon l'une des revendications 1 à 3, **caractérisé en ce que** la valeur de seuil pouvant être prédéfinie (7) est supérieure à 10, de préférence supérieure à 50, en particulier de préférence supérieure à 100 tours par minute.

5. Procédé selon l'une des revendications 1 à 4, **caractérisé en ce que** le signal (11) est indiqué à un compteur de glissement de pôle (18), dans lequel le compteur de glissement de pôle (18) est incrémenté, dans lequel, de préférence, en cas de dépassement du compteur de glissement de pôle (18) au-dessus d'une valeur de seuil de maintenance pouvant être prédéfinie, un signal de maintenance (20) est émis.

6. Procédé selon la revendication 5, **caractérisé en ce que** la valeur de seuil de maintenance pouvant être prédéfinie est de l'ordre de 2 à 10, de préférence 3 à 5.

7. Dispositif de reconnaissance de glissement de pôle pour reconnaître le glissement de pôle d'un générateur électrique (2), plus particulièrement d'un générateur synchrone, relié électriquement à un réseau d'alimentation en énergie(1), dans lequel un rotor (3) du générateur (2) est relié mécaniquement à un arbre de moteur (4) d'une machine à combustion interne (5), plus particulièrement d'un moteur à gaz, dans lequel sont prévus un capteur de vitesse de rotation (14) pour détecter une fréquence de rotation mécanique (n) de l'arbre de moteur (4) et un capteur de fréquence de réseau (15) pour détecter une fréquence de rotation électrique (f) du réseau d'alimentation en énergie (1), dans lequel est prévue une unité d'évaluation (10), dans lequel des lignes de signalisation (16) sont conçues pour indiquer à l'unité d'évaluation (10) la fréquence de rotation mécanique détectée (n) et la fréquence de rotation électrique détectée (f), dans lequel l'unité d'évaluation (10) est conçue pour déterminer un écart (6) de la fréquence de rotation mécanique (n) par rapport à la fréquence de rotation électrique (f), **caractérisé en ce que** l'unité d'évaluation (10) est conçue pour convertir dans la même unité la fréquence de rotation mécanique (n) et la fréquence de rotation électrique (f) et, en cas d'écart (6) supérieur à une valeur de seuil pouvant être prédéfinie (7), pendant une période pouvant être prédéfinie, émettre un signal (11) considéré comme la détection d'un glissement de pôle.

8. Dispositif de reconnaissance de glissement de pôle selon la revendication 7, **caractérisé en ce que** le générateur électrique (2) est relié électriquement par un dispositif de connexion (8), de préférence un interrupteur de secteur, au réseau d'alimentation en énergie (1), dans lequel l'unité d'évaluation (10) est conçue pour indiquer, via un câble de commutation (17), un signal de commutation (13) au dispositif de connexion (8) en cas de détection d'un glissement de pôle, dans lequel l'ouverture du dispositif de connexion (8) est déclenchée par le signal de commutation (13).

9. Dispositif de reconnaissance de glissement de pôle selon la revendication 7 ou 8, **caractérisé en ce qu'**un compteur de glissement de pôle (18) - pouvant de préférence être incrémenté - est prévu, dans lequel la ligne de comptage (19) est conçue pour indiquer le signal (11) via une ligne de comptage (19) au compteur de glissement de pôle (18), dans lequel, de préférence, en cas de dépassement du compteur de glissement de pôle (18) au-dessus d'une valeur de seuil de maintenance pouvant être prédéfinie, un signal de maintenance (20) est émis.
